# EUROPEAN PATENT APPLICATION

(11) **EP 1 927 825 A1**
(43) Date of publication of application: **04.06.2008**
(21) Application number: 06125277.1
(22) Date of filing: 01.12.2006
(51) Int. Cl.: G01D 5/24, G01D 3/08, B60R 21/015

(54) **Textile capacitive sensor electrode**

(71) Applicant: IEE International Electronics & Engineering S.A.R.L., 6468 Echternach (LU)
(72) Inventor: Chabach, Driss, 9676, Noertrange (LU); Maoujoud, Mohammed, 2619, Luxembourg (LU)
(74) Representative: Beissel, Jean

(57) **Abstract**

A textile capacitive sensor electrode includes a substantially planar capacitively sensitive region for detecting capacitive changes in an environment of the sensor electrode. The textile capacitive sensor electrode comprises at least one fabric including electrically conductive fibres arranged in such a way as to define the substantially planar capacitively sensitive region. The electrically conductive fibres comprise carbon fibres.

## Description

### Technical field

The present invention generally relates to a capacitive sensor electrode, e.g. in a capacitive sensing system for sensing occupancy states of a vehicle seat, and in particular to such an electrode made from textile material.

### Background Art

An interesting application of capacitive sensing systems is, for instance, the control of "intelligent" person-restraining systems in a vehicle. In such a system, data collected by the capacitive sensing system may be used to discriminate between a person and an object placed on a vehicle seat or to detect a person's attitude, approximate size and/or weight and like parameters. Based upon these data the person-restraining system may try to achieve optimal protection of the car occupants e.g. in a car accident.

More generally, a capacitive sensing system comprises at least one sensor electrode that forms a capacitor together with some counter-electrode. A person or object in proximity of this capacitor influences the electric field between the electrodes and thus the capacitance of the capacitor. The capacitance or changes thereof are then measured, which allows concluding to certain parameters relating to the person or object in the electric field. In a vehicle, the sensor electrode is advantageously arranged in the seating surface or the backrest of a vehicle seat, whereas the counter-electrode may be a dedicated electrode or provided by the car body. Indeed, a capacitive sensing system may also comprise more than one sensing electrode.

A capacitive seat occupancy classification system is proposed in EP 1 457 391 A1. The system disclosed therein comprises first and second capacitive electrode arrangements in a vehicle compartment. The first capacitive electrode arrangement is located in a seat of the vehicle and includes a sensing electrode and a shielding electrode. The sensing electrode is directed towards the occupant of the seat, whereas the shielding electrode is directed towards the seat frame. An insulating layer separates the sensing from the shielding electrode. The second capacitive electrode arrangement is arranged in a foot area associated with the vehicle seat. The system can operate in the so-called coupling mode, wherein the capacitive coupling between the first and second electrode arrangement is determined. Alternatively the system can operate in the so-called loading mode, wherein basically coupling between the sensing electrode of the first electrode arrangement and the car body is determined. In the latter operating mode, the sensing electrode and the shielding electrode of the first electrode arrangement are driven by the same AC voltage, so that the shielding electrode prevents the electric field of the sensing electrode from coupling with the seat frame. This dramatically increases the sensitivity of the sensing electrode in direction of the occupant. A similar electrode configuration is also known from US 5,166,679. When a shielding electrode is used, its dimensions and arrangement with respect to the sensing electrode are preferably adapted so that the alternating field produced by the sensing electrode is effectively directed into the desired direction(s). The capacitive coupling is determined by measuring (the amplitude and/or phase of) the electrical current that flows into the sensing electrode in response to the applied AC voltage.

Integrating a sensing electrode and, possibly, a shielding electrode into the backrest or the seating surface of a vehicle seat implies particular requirements regarding the material to be used for such an electrode. The electrode should exhibit sufficient flexibility to undergo deformations of the vehicle seat without negatively affecting a seat occupant's comfort.

For integration into vehicle seats, foil-type electrodes have been proposed, i.e. electrodes provided as a thin layer of conductive material (e.g. silver ink) applied on a thin and flexible dielectric carrier foil (made e.g. of PET, PEN, PI or like materials). Foil-type electrodes, however, have usually a low permeability for air and moisture, which negatively affects the seating comfort.

As an alternative to foil-type electrodes, textile electrodes have been proposed, including metallic or metallised fibres arranged in a pattern such that a substantially planar electrode is achieved; see e.g. WO 00/11443 A1 for reference. Although the problem of air permeability is substantially reduced in textile electrodes, there is still room for further improvements, e.g. regarding mechanical robustness and resistivity against corrosion. Indeed, corrosion may be an issue in capacitive sensing systems as soon as moisture or humidity is involved. In safety-critical applications, for instance in seat occupancy detection systems, system check routines may be run that cause voltage differences between an electrode and other parts of the system. If the region over which the potential difference exists is wet, electrolysis may occur, potentially causing corrosion of the electrode. For more details about corrosion-related problems and proposed solutions, the interested reader is referred to the European patent applications 06 115 666.7 and 06 115 667.5.

The documents cited hereinbefore are herewith incorporated herein by reference in their entirety.

### Technical problem

It is an object of the present invention to provide an improved capacitive sensor electrode.

This object is achieved by a textile capacitive sensing electrode as claimed in claim 1.

### General Description of the Invention

A textile capacitive sensor electrode is proposed that includes a substantially planar capacitively sensitive region for detecting capacitive changes in an environment of the sensor electrode. The textile capacitive sensor electrode comprises at least one fabric including electrically conductive fibres arranged in such that they define the substantially planar capacitively sensitive region. For the purposes of the present, the term "fabric" is generally intended to encompass any material made of interlacing fibres (e.g. a nonwoven fabric, a knitted fabric and/or a woven fabric). According to an important aspect of the invention, the electrically conductive fibres comprise carbon fibres. As will be appreciated, the carbon fibres enhance the mechanical strength of the textile electrode and exhibit outstanding corrosion resistance.

Advantageously, the conductive fibres included in the fabric may be exclusively carbon fibres.

According to a preferred embodiment of the invention, the fabric comprises electrically conductive yarn incorporating at least a part of and possibly all the carbon fibres. The electrically conductive yarn incorporating the carbon fibres may be an integrating part of the fabric or be sewn into or otherwise attached to it. It will be appreciated that the electrically conductive yarn incorporating the carbon fibres might comprise electrically conductive or insulating fibres different from the carbon fibres. Such conductive or insulating fibres could include natural fibres of vegetal or animal origin (e.g. cotton, wool, etc.) and/or synthetic fibres (e.g. acrylic fibres, nylon, polyester or the like). Preferably, however, the electrically conductive yarn incorporating the carbon fibres consists of a single carbon fibre strand or a plurality of carbon fibre strands.

It should be noted that, in addition to electrically conductive yarn incorporating the carbon fibres, the fabric might comprise some other kind of (electrically insulating or conducting) yarn, woven or knitted with the electrically conductive yarn incorporating the carbon fibres. For instance, in case of a woven fabric, the warp threads might be provided, at least in part, as carbon fibre threads, whereas the weft might only comprise the other kind of yarn or vice-versa. In such a fabric, the carbon fibre threads thus would all be parallel, which is considered advantageous because of the simpler manufacturing. Of course, other arrangements of the different kinds of threads are also possible. In embodiments, wherein the carbon fibre threads are all parallel, interconnections between the carbon fibre threads could be provided with other conductive threads extending transversally with respect to the carbon fibre threads. If transversal connections of parallel carbon fibre threads are desired, they may of course also be provided through carbon fibre threads. As will be appreciated, by arranging carbon fibres or carbon fibre threads in parallel or using threads comprising a plurality of carbon fibre strands, one can reduce the electrical resistance. For a practical application, the surface resistivity of the electrically conductive portion of the electrode is preferably below 0.5 Ohm/sq. It should be noted, however that the suitability of the surface resistivity depends on the driving and evaluation circuit that carries out the capacitive measurement. The surface resistivity may therefore be substantially higher or lower than the value indicated before if the electronics are configured accordingly.

A preferred embodiment of the invention relates to a capacitive electrode arrangement, which comprises a textile capacitive sensor electrode as generally described hereinbefore, a shielding electrode and a spacer, the shielding electrode being arranged substantially parallel with the sensing electrode by the spacer. Advantageously, the shielding electrode is a textile electrode of similar construction as the sensor electrode. The shielding electrode may e.g. comprise at least one fabric of a nonwoven fabric, a knitted fabric and a woven fabric and/or include carbon fibres arranged in such a way as to define a substantially planar conductive region for shielding the capacitively sensitive region of the sensor electrode. Preferably, the conductive region of the shielding electrode is larger than the conductive region of the sensing electrode, so as to provide efficient shielding when in use.

According to a most preferred embodiment of the capacitive electrode arrangement, there is provided a warp-knitted spacer fabric having a first textile layer including the capacitive sensor electrode, a second textile layer including the shielding electrode and a pile thread spacing the first and second textile layers.

### Brief Description of the Drawings

Further details and advantages of the present invention will be apparent from the following detailed description with reference to the attached drawings, wherein:
Fig. 1 is an exploded perspective view of a capacitive sensing system, e.g. for a vehicle seat, including a textile sensing electrode and a textile shielding electrode;
Fig. 2 is a cross sectional view of the capacitive sensing system of Fig. 1;

### Description of Preferred Embodiments

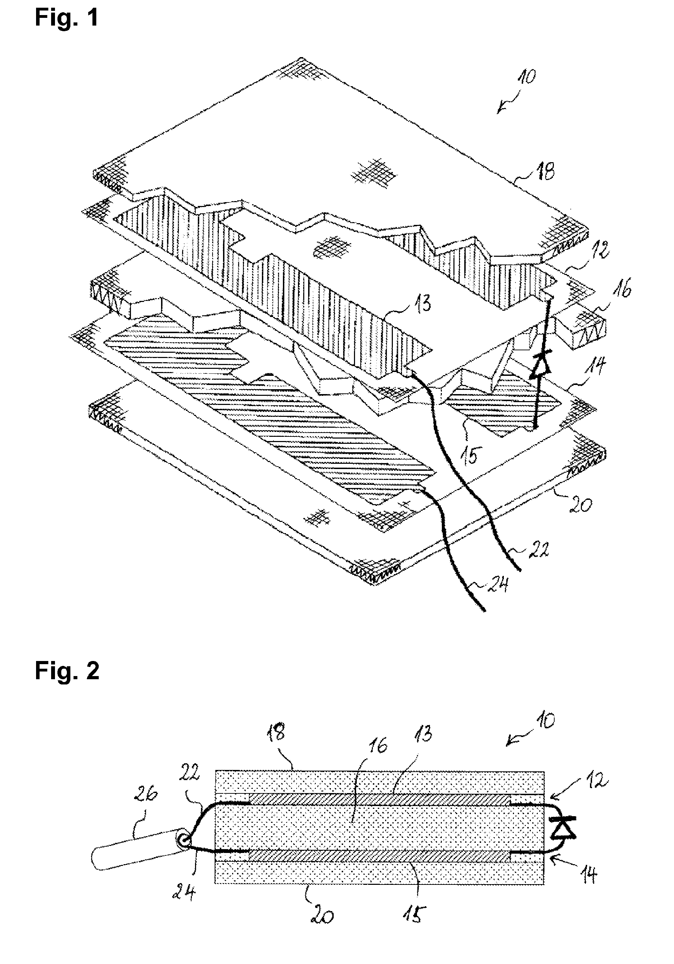

Figs. 1 and 2 illustrate a preferred embodiment of a capacitive sensing system 10, e.g. for a vehicle seat. The capacitive sensing system 10, includes an electrode arrangement provided as a sandwich structure with a generally planar sensing electrode 12, a likewise generally planar shielding electrode 14 and an insulating spacing layer 16 sandwiched by the sensing electrode 12 and the shielding electrode 14. The electrodes 12 and 14 are textile electrodes, which have enhanced haptic properties with respect to conventional foil-based electrodes. The electrode arrangement may be arranged in a textile pocket or, as illustrated in the figures, between two outer fabric layers 18, 20. The electrodes are connected to a driving and evaluation circuit (not shown) via leads 22, 24 and the coaxial cable 26.

The sensing electrode 12 comprises a generally flat fabric of electrically insulating textile fibres into which electrically conductive fibres have been incorporated in such a way that they define an electrically conductive region 13 of a desired shape. The electrically conductive region 13 forms the capacitively sensitive portion of the sensing electrode 12. The shielding electrode 14 is of similar construction and includes also a generally flat fabric of electrically insulating fibres into which electrically conductive fibres have been incorporated in such a way they define an electrically conductive region 15 of a desired shape. The electrically conductive region 15 of the shielding electrode 14 is of essentially the same shape as the capacitively sensitive region 13 of the sensing electrode 12 but a little larger so that it would totally cover capacitively sensitive region 13 of the sensing electrode 12 if it were directly superposed to the latter. In operation, the electrically conductive region 15 of the shielding electrode 14 takes on the shielding of the capacitively sensitive region 13. For both the sensing and the shielding electrodes 12, 14, the electrically conductive fibres may be provided as carbon fibres, or yarn comprising or consisting of such carbon fibres.

Electrodes consisting of carbon fibres woven with polyester have been repetitively subjected to folding stress with a metal rod of 1 mm radius. During the test, electrical resistance was measured online versus the number of test cycles. The tested electrodes were embedded in a felt pocket. After 40000 cycles of the compression-sliding test, the relative resistance change stayed below 10%. For comparison, a foil-type electrode (silver ink printed on a first Kapton™ polyimide film that was laminated with a second one) became unusable at about 4000 cycles of the test because cracks in the printed layer caused the resistance of the electrode to tend towards that of an insulator.

When the capacitive sensing system 10 is operationally integrated into the seating portion or the backrest of a vehicle seat, the electrodes 12, 14 are arranged substantially parallel to the surface of the seating portion or the backrest, with the sensing electrode 12 being closer to that surface than the shielding electrode 14. The electrodes 12, 16 are shown generally U-shaped. It should be noted, however, that other shapes are possible and, in some cases even desirable. The shape of the electrodes 12, 16 can be adjusted depending on constraints resulting from the seat design, e.g. the geometry of seam lines and/or crimp channels along which the seat cover is attached to the cushion.

The capacitive measurement is achieved by applying alternating signals of identical amplitude and phase to both the sensing electrode and the shielding electrode. If the capacitance between the sensing electrode 12 and a counter-electrode (e.g. the vehicle body in case of an occupancy detection system) varies, the loading current drawn by the sensing electrode 12 changes accordingly. The driving and evaluation circuit measures that drawn current, which allows detecting the presence and classification of an object in the electrical field, e.g. a car occupant. Since the shielding electrode 14 is driven with the same voltage as the sensing electrode 12, the sensing electrode 12 is only sensitive into the direction facing away from the shielding electrode 14.

It is shown in the figures that a diode 28 is connected between the shielding electrode 14 and the sensing electrode 12. During the capacitive measurement, the diode 28 is substantially passive because the electrodes 12 and 14 are driven with the same voltage during that time. The diode 28 is useful for measuring whether the electric path formed by the lead 24, the shielding electrode 14, the diode 28, the sensing electrode 12 and the lead 22 is interrupted or shorted. To check circuit integrity, the driving and evaluation circuit test whether a current in forward direction of the diode can pass. If this is not the case, the circuit is deemed interrupted. A short circuit is detected if a current passes not only in but also against the forward direction of the diode. Since these system check routines use DC current, conventional systems suffer from electrolysis occurring if the spacing material between the electrodes is wet. Those skilled will appreciate that the carbon fibres allow overcoming the drawbacks related to metal or metallised electrodes, such as oxidation, electrical migration and electrolysis.

The spacer layer 16 could be a knitted, woven or non-woven fabric (e.g. a felt) or a multilayered structure of such fabrics. Preferably, the spacer 16 comprises a 3D spacer fabric, as in the illustrated case. In Fig. 1, the electrode layers 12 and 14 as well as the spacing textile are represented as separate elements. It should be noted, however, that according to a preferred embodiment of the capacitive sensing system, the spacing textile is a warp-knitted spacer fabric whose cover layers include the capacitive sensor electrode 12 and the shielding electrode 14, respectively. An electrically insulating pile thread extends between the cover layers to provide the thickness of the spacer fabric.

Although the usefulness of capacitive sensing systems has mainly been discussed with respect to their application in vehicle seat occupancy detection systems, it will be understood that the present invention may be used in capacitive sensing systems in general, without necessarily being limited to the automotive field. It will be understood, nevertheless, that the invention is preferably implemented in a capacitive occupancy sensing system for a vehicle.

## Claims

1. A textile capacitive sensor electrode including a substantially planar capacitively sensitive region for detecting capacitive changes in an environment of the sensor electrode, said textile capacitive sensor electrode comprising at least one fabric wherein said fabric includes electrically conductive fibres arranged in such a way as to define said substantially planar capacitively sensitive region,
**characterized in that**
said electrically conductive fibres comprise carbon fibres.

2. The textile capacitive sensor electrode as claimed in claim 1 wherein said fabric comprises a nonwoven fabric and/or a knitted fabric and/or a woven fabric.

3. The textile capacitive sensor electrode as claimed in claim 1 or 2, wherein said fabric comprises electrically conductive yarn incorporating said carbon fibres.

4. The textile capacitive sensor electrode as claimed in claim 3, wherein said electrically conductive yarn incorporating said carbon fibres consists of a single carbon fibre strand or a plurality of carbon fibre strands.

5. The textile capacitive sensor electrode as claimed in claim 2, wherein said electrically conductive yarn incorporating said carbon fibres comprises electrically conductive or insulating fibres different from said carbon fibers.

6. The textile capacitive sensor electrode as claimed in any one of claims 3 to 5, wherein said fabric comprises electrically insulating yarn, woven or knitted with said electrically conductive yarn incorporating said carbon fibres.

7. The textile capacitive sensor electrode as claimed in any one of claims 2 to 6, wherein said fabric comprises electrically conductive yarn substantially free of carbon fibres, woven or knitted with said electrically conductive yarn incorporating said carbon fibres.

8. A capacitive electrode arrangement, comprising a textile capacitive sensor electrode as claimed in any one of claims 1 to 7, a shielding electrode and a spacer, said shielding electrode being arranged substantially parallel with said sensing electrode by said spacer.

9. The capacitive electrode arrangement as claimed in claim 8, wherein said shielding electrode comprises at least one fabric of a nonwoven fabric, a knitted fabric and a woven fabric, wherein said fabric includes carbon fibres arranged in such a way as to define a substantially planar conductive region for shielding said capacitively sensitive region of the sensor electrode.

10. The capacitive electrode arrangement as claimed in claim 8 or 9, comprising a warp-knitted spacer fabric having a first textile layer including said capacitive sensor electrode, a second textile layer including said shielding electrode and a pile thread for spacing said first and second textile layers.
